(19) Europäisches Patentamt
European Patent Office
Office européen des brevets

(11) **EP 2 988 326 A1**

(12) **EUROPEAN PATENT APPLICATION**

(43) Date of publication:
**24.02.2016 Bulletin 2016/08**

(51) Int Cl.:
*H01L 21/66* (2006.01)    *G01R 31/26* (2006.01)

(21) Application number: **15172670.0**

(22) Date of filing: **18.06.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(30) Priority: **21.08.2014 JP 2014168812**

(71) Applicant: **Kabushiki Kaisha Toshiba
Tokyo 105-8001 (JP)**

(72) Inventors:
• **Ohashi, Teruyuki
Tokyo, 105-8001 (JP)**
• **Iljima, Ryosuke
Tokyo, 105-8001 (JP)**

(74) Representative: **Moreland, David et al
Marks & Clerk LLP
Aurora
120 Bothwell Street
Glasgow G2 7JS (GB)**

(54) **SEMICONDUCTOR DEVICE TESTING APPARATUS, SEMICONDUCTOR DEVICE TESTING METHOD, AND SEMICONDUCTOR DEVICE MANUFACTURING METHOD**

(57)    A semiconductor device testing apparatus (100) according to an embodiment includes: a first terminal (12) and a second terminal (14) that apply voltage to a semiconductor device; and a light source (16) that irradiates the semiconductor device (18) with ultraviolet light.

FIG.1

**Description**

CROSS-REFERENCE TO RELATED APPLICATION

This application is based upon and claims the benefit of priority from Japanese Patent Application No. 2014-168812, filed on August 21, 2014, the entire contents of which are incorporated herein by reference.

FIELD

Embodiments described herein relate generally to a semiconductor device testing apparatus, a semiconductor device testing method, and a semiconductor device manufacturing method.

BACKGROUND

A wide bandgap semiconductor such as SiC (silicon carbide), GaN (gallium nitride), or C (diamond) has better physical values than Si (silicon), in terms of dielectric breakdown strength, electron saturation velocity, thermal conductivity, and the like. Accordingly, such materials are expected as materials for next-generation semiconductor devices.

However, a semiconductor device using a wide bandgap semiconductor does not realize adequate characteristics, particularly in terms of reliability. The reliability of the gate insulating film of a MOSFET (Metal Oxide Semiconductor Field Effect Transistor) in particular needs to be improved.

Normally, the reliability or the like of a gate insulating film is evaluated after a MOSFET is produced. However, production of a MOSFET using a wide bandgap semiconductor requires a longer time and higher costs, compared with production of a MOSFET using Si. Therefore, it is preferable to evaluate the reliability of a gate insulating film by using a MOS capacitor that can be more readily manufactured, instead of a MOSFET.

BRIEF DESCRIPTION OF THE DRAWINGS

FIG. 1 is a schematic view of a semiconductor device testing apparatus according to a first embodiment;
FIG. 2 is a schematic cross-sectional view of an example of a semiconductor device according to the first embodiment;
FIGS. 3A and 3B are diagrams for explaining a function of a semiconductor device testing method according to the first embodiment;
FIG. 4 is a diagram for explaining another function of the semiconductor device testing method according to the first embodiment;
FIG. 5 is a diagram for explaining yet another function of the semiconductor device testing method according to the first embodiment;

FIG. 6 is a diagram for explaining an effect of the semiconductor device testing method according to the first embodiment;
FIGS. 7A and 7B are diagrams for explaining another effect of the semiconductor device testing method according to the first embodiment; and
FIG. 8 is a schematic view of a semiconductor device testing apparatus according to a second embodiment.

DETAILED DESCRIPTION

A semiconductor device testing apparatus according to an embodiment includes: a first terminal and a second terminal applying voltage to a semiconductor device; and a light source irradiating ultraviolet light to the semiconductor device.

The following is a description of embodiments, with reference to the accompanying drawings. In the following description, same or similar components are denoted by same reference numerals, and explanation of components described once may not be repeated.

In this specification, a "wide bandgap semiconductor" means a semiconductor having a wider band gap energy than that of silicon.

(First Embodiment)

A semiconductor device testing apparatus according to this embodiment includes: a first terminal and a second terminal that apply voltage to a semiconductor device; and a light source that irradiates the semiconductor device with ultraviolet light.

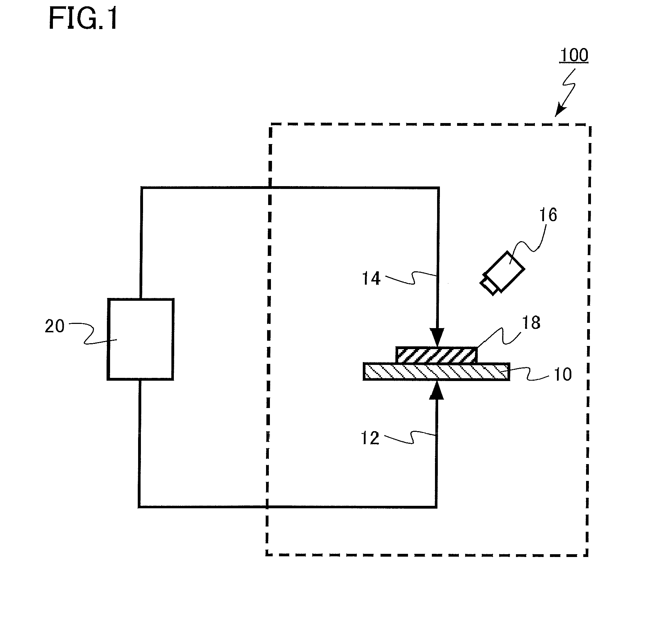

FIG. 1 is a schematic view of the semiconductor device testing apparatus according to this embodiment. The semiconductor device testing apparatus 100 includes a stage 10, a first terminal 12, a second terminal 14, and a light source 16.

A semiconductor device 18 to be tested can be mounted on the stage 10. For example, the stage 10 is an X-Y stage that can move in the X-direction and the Y-direction, which are perpendicular to each other. At least part of the stage 10 is conductive, for example. For example, the surface of the stage 10 to be in contact with the semiconductor device 18 is made of a conductive material.

The first terminal 12 and the second terminal 14 have the function to apply voltage or current to the semiconductor device 18. The first terminal 12 and the second terminal 14 are connected to a power supply 20 located outside the semiconductor device testing apparatus 100.

The first terminal 12 and the second terminal 14 are conductive probes, for example. Also, the first terminal 12 can be electrically connected to the conductive stage 10, for example. As the first terminal 12 is electrically connected to the conductive stage 10, voltage can be applied to the semiconductor device 18 from the back surface side thereof in contact with the stage 10.

The first terminal 12 and the second terminal 14 also function as terminals that measure the electrical characteristics of the voltage to be applied to the semiconductor device 18, the current flowing in the semiconductor device 18.

The light source 16 irradiates the semiconductor device 18 with ultraviolet light. The light source 16 is an LED (Light-Emitting Diode) that emits ultraviolet light of 400 nm or shorter in wavelength, for example. The light source 16 is not necessarily an LED, but may be an ultraviolet lamp, for example.

The light source 16 can emit ultraviolet light having a higher energy than the band gap energy of the semiconductor used in the semiconductor device 18. The light source 16 may be capable of emitting light of different wavelengths. For example, LEDs having different luminescence peaks are provided so that light of different wavelengths can be emitted.

Also, the light source 16 preferably has a mechanism for changing the intensity of ultraviolet light. For example, the light source 16 has an intensity variable circuit that varies an intensity of the ultraviolet light. For example, the light source 16 has a variable resistor that changes the current flowing in the light source 16, so that the intensity of ultraviolet light can be changed.

The semiconductor device 18 to be tested includes a wide bandgap semiconductor layer, for example. The wide bandgap semiconductor layer is made of SiC (silicon carbide), GaN (gallium nitride), or C (diamond), for example.

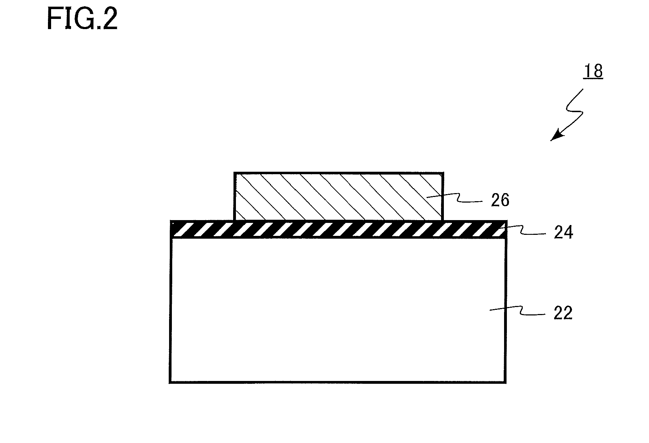

FIG. 2 is a schematic cross-sectional view of an example of the semiconductor device according to this embodiment. The semiconductor device 18 is a MOS capacitor that includes a semiconductor layer 22, a gate insulating film (an insulating film) 24 provided on the semiconductor layer 22, and a gate electrode (an electrode) 26 provided on the gate insulating film 24.

The semiconductor layer 22 is a wide bandgap semiconductor, for example, and is n-type SiC, for example. The gate insulating film 24 is a silicon oxide film, for example. The gate electrode 26 is a stacked film formed with polycrystalline silicon and aluminum, for example.

The semiconductor device 18 to be tested may be a semiconductor wafer formed with MOS capacitors that are the same as the MOS capacitor shown in FIG. 2.

The light source 16 is located above the stage 10, and is designed to emit ultraviolet light to the MOS capacitor from the gate electrode 26 side of the MOS capacitor.

Next, a semiconductor device testing method according to this embodiment is described. The semiconductor device testing method according to this embodiment use the above described semiconductor device testing apparatus 100.

The semiconductor device testing method according to this embodiment includes: irradiating a semiconductor device with ultraviolet light, the semiconductor device including a capacitor formed with a semiconductor layer, an insulating film provided on the semiconductor layer, and an electrode provided on the insulating film; and applying voltage between the semiconductor layer and the electrode under a first condition that the electrode has a negative voltage when the semiconductor layer is an n-type semiconductor, and the electrode has a positive voltage when the semiconductor layer is a p-type semiconductor, the semiconductor device being irradiated with the ultraviolet light. After an electrical stress is applied to the insulating film by applying voltage between the semiconductor layer and the electrode under the first condition, voltage is applied between the semiconductor layer and the electrode under a second condition, and the electrical characteristics of the capacitor are evaluated.

First, a semiconductor wafer including MOS capacitors that are the same as the MOS capacitor shown in FIG. 2 is mounted on the stage 10 of the semiconductor device testing apparatus 100 shown in FIG. 1. The semiconductor wafer is an example of the semiconductor device 18. In the description below, an example case where the semiconductor layer 22 of the semiconductor device 18 is n-type SiC is described.

The semiconductor wafer mounted on the stage 10 is irradiated with ultraviolet light from the light source 16. The ultraviolet light has a higher energy than the band gap energy of the semiconductor layer 22.

Ultraviolet light having a higher energy than the band gap energy of the semiconductor layer 22 is ultraviolet light of a wavelength that satisfies the relationship,

$$\lambda \le hc/eEg,$$

where "$\lambda$" represents the wavelength of the ultraviolet light, "h" represents Planck's constant, "c" represents light speed, "e" represents elementary charge, and "Eg" represents the band gap of the semiconductor layer 22.

Specifically, the wavelength of the ultraviolet light is 368 nm or shorter in a case where the semiconductor layer 22 is SiC, is 365 nm or shorter in a case where the semiconductor layer 22 is GaN, and is 220 nm or shorter in a case where the semiconductor layer 22 is diamond.

While the semiconductor wafer is irradiated with ultraviolet light, voltage is applied between the semiconductor layer 22 and the gate electrode 26 under the first condition that the gate electrode 26 has a negative voltage in a case where the semiconductor layer 22 is an n-type semiconductor, and the gate electrode 26 has a positive voltage in a case where the semiconductor layer 22 is a p-type semiconductor. As voltage is applied between the semiconductor layer 22 and the gate electrode 26, an electrical stress is applied to the gate insulating film 24. In a case where the semiconductor layer 22 is n-type SiC, a negative voltage is applied to the gate electrode 26.

After that, the ultraviolet irradiation to the semiconductor wafer is stopped. The electrical characteristics of the MOS capacitor after the application of the electrical stress are then measured and evaluated. At this point, voltage is applied between the semiconductor layer 22 and the gate electrode 26 under a second condition that the absolute value of the voltage applied between the semiconductor layer 22 and the gate electrode 26 is lower than that under the first condition, for example.

To evaluate the electrical characteristics of the MOS capacitor, the variation (shift amount) in the flat band voltage of the MOS capacitor from prior to application of the electrical stress is evaluated, and a defect is detected when the variation exceeds a predetermined value. Alternatively, a leakage current of the MOS capacitor is evaluated, and a defect is detected when the leakage current exceeds a predetermined value.

In a case where the electrical characteristics of the MOS capacitor are measured under the second condition, the ultraviolet irradiation to the semiconductor wafer is preferably stopped, so as to reduce the influence of the ultraviolet light on the electrical characteristics. However, the measurement can be carried out even if the ultraviolet irradiation to the semiconductor wafer is continued.

In the above manner, a reliability test is conducted on the MOS capacitor. Specifically, the reliability test is a time-dependent dielectric breakdown (TDDB) test, a time-zero dielectric breakdown (TZDB) test, a constant-voltage stress test, or a constant-current stress test, for example. In the case of a time-dependent dielectric breakdown test or a time-zero dielectric breakdown test that breaks down the gate insulating film 24, the measurement under the second condition is not necessarily carried out.

In this embodiment, the stage 10 is made of an electrically conductive material such as a metal. The first terminal 12 is electrically connected to the conductive stage 10. Meanwhile, the second terminal 14 is electrically connected to the gate electrode 26.

The power supply 20 applies voltage between the first terminal 12 and the second terminal 14. Accordingly, voltage is applied between the back surface side of the semiconductor wafer or the back surface side of the semiconductor layer 22 and the gate electrode 26, and an electrical stress is applied to the gate insulating film 24.

In the following, the functions and effects of this embodiment are described.

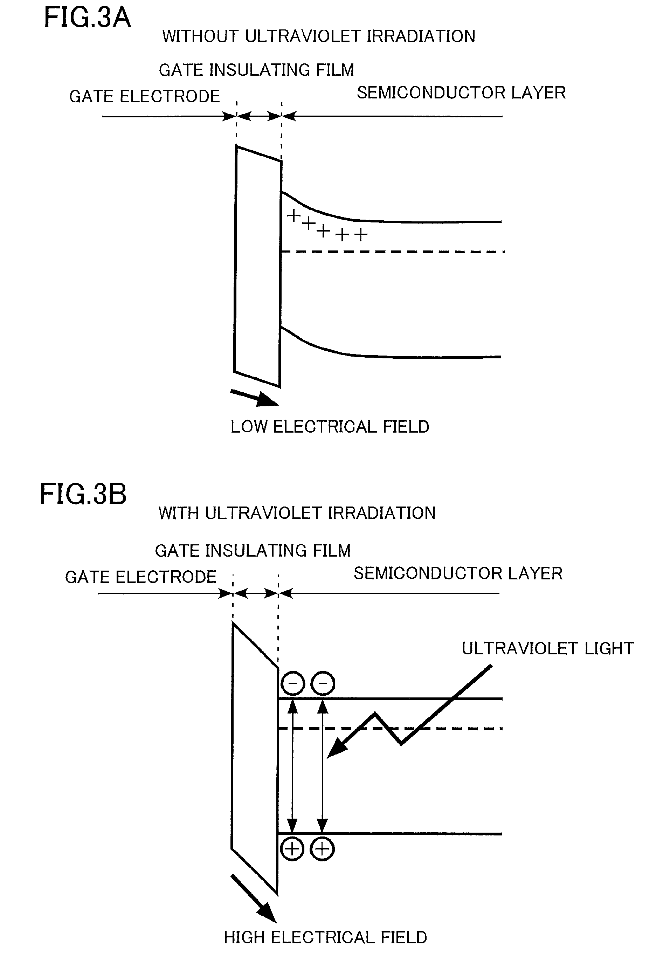

FIGS. 3A and 3B are diagrams for explaining a function of the semiconductor device testing method according to this embodiment. FIG. 3A is a band diagram of the MOS capacitor in a case where ultraviolet irradiation is not performed, and FIG. 3B is a band diagram of the MOS capacitor in a case where ultraviolet irradiation is performed. In this case, the semiconductor layer 22 is of the n-type, and a negative voltage is applied to the gate electrode 26.

As shown in FIG. 3A, in a case where ultraviolet irradiation is not performed, a depletion layer extends into the semiconductor layer 22, and a high electrical field is not applied to the gate insulating film 24. Therefore, in a case where the semiconductor layer 22 is of the n-type, for example, a sufficient electrical stress cannot be applied to the gate insulating film 24 so as to evaluate the reliability with a negative gate bias. Particularly, in a wide bandgap semiconductor, the electrical stress to be applied becomes smaller, due to low intrinsic carrier concentration.

As shown in FIG. 3B, in a case where ultraviolet irradiation with ultraviolet light having a higher energy than the band gap energy of the semiconductor layer 22 is performed, on the other hand, holes as the minority carriers are excited in the semiconductor layer 22. As a result, expansion of a depletion layer is restrained, and a high electrical field is applied to the gate insulating film 24. Accordingly, a sufficient electrical stress to evaluate reliability can be applied to the gate insulating film 24.

In a case where the semiconductor layer 22 is of the p-type, ultraviolet irradiation is performed, so that electrons as the minority carriers are excited in the semiconductor layer 22. Accordingly, a sufficient electrical stress can be applied to the gate insulating film 24 so as to evaluate the reliability with a positive gate bias.

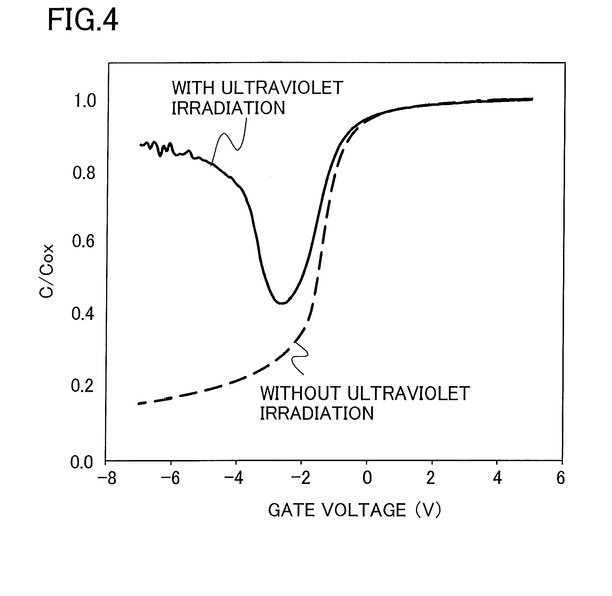

FIG. 4 is a diagram for explaining a function of the semiconductor device testing method according to this embodiment. This diagram shows a comparison between the result of measurement of the C-V (capacitance-voltage) characteristics of the MOS capacitor with ultraviolet irradiation and the result of measurement of the C-V characteristics of the MOS capacitor without ultraviolet irradiation. The abscissa axis indicates the gate voltage, and the ordinate axis indicates the relative value of gate capacitance. The semiconductor layer 22 is n-type SiC.

As shown in FIG. 4, the value of the capacitance with a negative gate bias becomes higher with ultraviolet irradiation. This is because holes excited as the minority carriers in the semiconductor layer 22 through ultraviolet irradiation prevent expansion of a depletion layer, and the capacitance of the gate insulating film 24 is mainly observed.

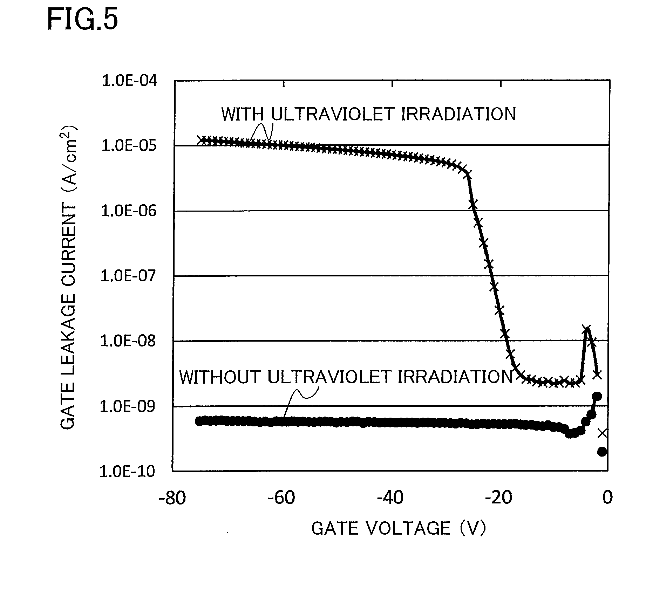

FIG. 5 is a diagram for explaining a function of the semiconductor device testing method according to this embodiment. This diagram shows a comparison between the result of measurement of the gate leakage current of the MOS capacitor with ultraviolet irradiation and the result of measurement of the gate leakage current of the MOS capacitor without ultraviolet irradiation. The abscissa axis indicates the gate voltage, and the ordinate axis indicates the gate leakage current. The semiconductor layer 22 is n-type SiC.

As shown in FIG. 5, the gate leakage current with a negative gate bias becomes higher with ultraviolet irradiation. This is because holes excited as the minority carriers in the semiconductor layer 22 through ultraviolet irradiation prevent expansion of a depletion layer, and a high electrical field is applied to the gate insulating film 24.

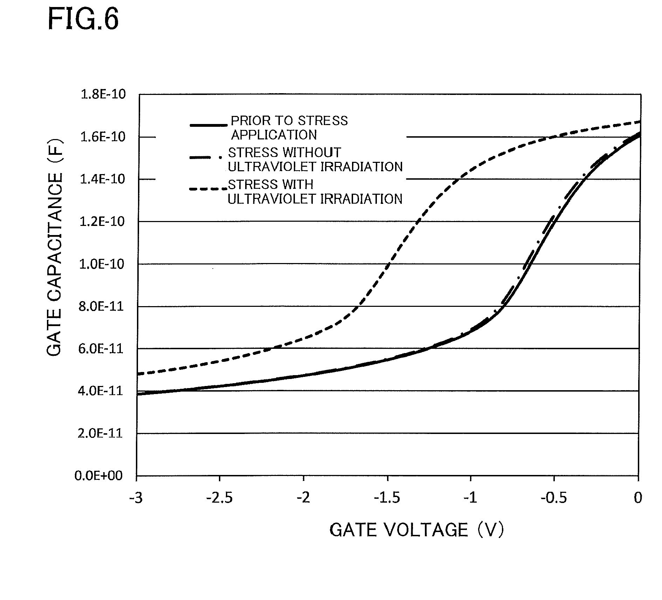

FIG. 6 is a diagram for explaining an effect of the semiconductor device testing method according to this embodiment. This diagram shows changes in the gate capacitance before and after application of an electrical stress to the MOS capacitor. The abscissa axis indicates the gate voltage at the time of capacitance measurement, and the ordinate axis indicates the gate capacitance.

While the MOS capacitor having the semiconductor layer 22 that is n-type SiC was irradiated with ultraviolet light having a higher energy than the band gap energy of SiC, a negative bias of -20 V was applied as a constant-voltage stress to the gate electrode 26 for 1000 seconds under the first condition. After that, the ultraviolet irradiation was stopped, and the gate capacitance was measured. At this point, the measurement was carried out under the second condition that the absolute value of the gate voltage was lower than that under the first condition, or was carried out at -3 to 0 V. For comparison, a constant-voltage stress was also applied to a MOS capacitor that is n-type SIC without ultraviolet irradiation, and the gate capacitance was measured in the same manner as above.

As shown in FIG. 6, in the case where ultraviolet irradiation was not performed at the time of stress application, there were hardly any changes in the value of the flat band voltage before and after the stress application. This is supposedly because a depletion layer expanded into the semiconductor layer 22, and a sufficient voltage stress was not applied to the gate insulating film 24.

In the case where ultraviolet irradiation was performed at the time of stress application, on the other hand, there were changes in the value of the flat band voltage. This is supposedly because expansion of a depletion layer in the semiconductor layer 22 was restrained, and a sufficient electrical field was applied to the gate insulating film 24. That is, this is supposedly because carriers were trapped into the gate insulating film 24 by virtue of the application of a high electrical field to the gate insulating film 24, and variation (shift) was caused in the flat band voltage.

As a result, it became apparent that a sufficient electrical stress can be applied to a MOS capacitor through ultraviolet irradiation, and a reliability test can be conducted on the reliability of an n-type MOS capacitor with a negative gate bias.

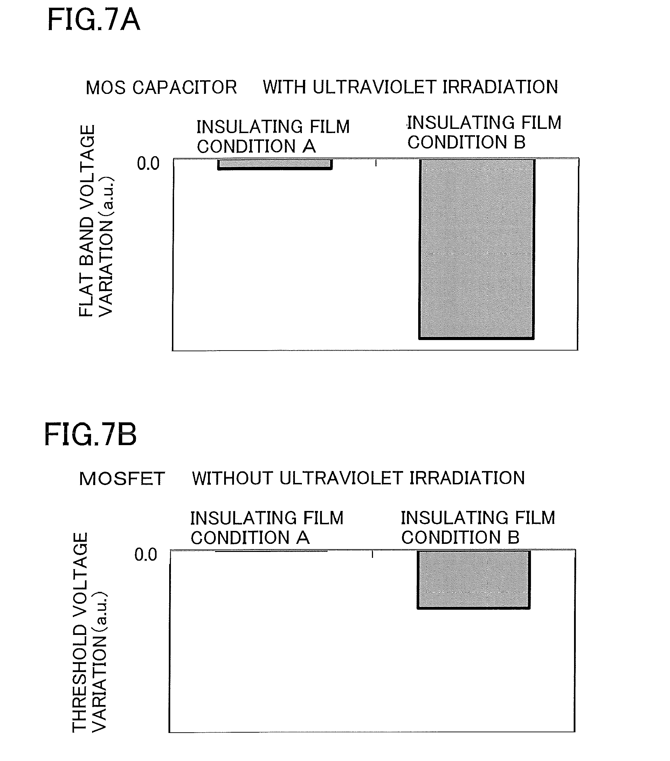

FIGS. 7A and 7B are diagrams for explaining an effect of the semiconductor device testing method according to this embodiment. This diagram shows a correlation between reliability evaluation of MOS capacitors and reliability evaluation of MOSFETs.

Insulating films were formed under two different process conditions (an insulating film condition A and an insulating film condition B), to produce MOS capacitors formed with SiC and MOSFETs. In each of the MOS capacitors, the semiconductor layer 22 is of the n-type. Each of the MOSFETs is an n-type MOSFET that includes a p-type channel region and an n-type source region formed in an n-type semiconductor layer through ion implantation.

While the MOS capacitors under the two different insulating film conditions were irradiated with ultraviolet light having a higher energy than the band gap of SiC, a negative bias of -20 V was applied as a constant-voltage stress to the gate electrodes 26 for 1000 seconds. After that, the ultraviolet irradiation was stopped, and the gate capacitances were measured. The variation in the flat band voltage was then evaluated.

The MOSFETs under the two different insulating film conditions were not irradiated with ultraviolet light, and a negative bias of -20 V was applied as a constant-voltage stress to the gate electrodes 26 for 1000 seconds. After that, the transistor characteristics were measured, and the variation in the threshold voltage was evaluated.

FIG. 7A shows the results of the evaluation of the MOS capacitors, and FIG. 7B shows the results of the evaluation of the MOSFETs. Under the insulating film condition A that causes the smaller variation in the threshold voltage of a MOSFET, the variation in the flat band voltage of a MOS capacitor is small. Under the insulating film condition B that causes the larger variation in the threshold voltage of a MOSFET, on the other hand, the variation in the flat band voltage of a MOS capacitor is large. In this manner, there is a correlation between the results of reliability evaluation of MOS capacitors and the results of reliability evaluation of MOSFETs. Accordingly, it became apparent that reliability evaluation of the MOS capacitor according to this embodiment is effective in evaluating the reliability of a MOSFET as a final product.

Normally, the reliability of a gate insulating film is evaluated after a MOSFET is produced. However, production of a MOSFET using a wide bandgap semiconductor particularly requires a longer time and higher costs, compared with production of a MOSFET using Si. To be more specific, production of a SiC MOSFET requires ion implantation at substrate temperature increased to approximately 800°C, and crystallinity recovery or activation annealing at approximately 1900°C. This makes the production of the MOSFET difficult. Therefore, it is preferable to evaluate reliability of a gate insulating film by using a MOS capacitor that can be more readily manufactured, instead of a MOSFET. In a case where a MOS capacitor is used, however, a sufficient electrical field cannot be applied to the gate insulating film 24 under a bias condition that a depletion layer expands into the semiconductor layer 22, such as a negative gate bias condition if the semiconductor layer 22 is of the n-type, or a positive gate bias condition if the semiconductor layer 22 is of the p-type. Therefore, it is difficult to evaluate reliability.

Also, a p-type SiC wafer is particularly difficult to come by. Therefore, in a semiconductor device using SiC, it is difficult to conduct reliability evaluation with a MOS capacitor under a negative gate bias condition.

With the semiconductor device testing apparatus and the semiconductor device testing method according to this embodiment, minority carriers are excited in the semiconductor layer 22 through ultraviolet irradiation, so that the reliability of the gate insulating film can be effectively evaluated with a MOS capacitor under a bias condition that a depletion layer expands into the semiconductor layer 22.

In the semiconductor device testing apparatus according to this embodiment, the light source 16 preferably has a mechanism for changing the intensity of ultraviolet light. With the mechanism for changing the intensity of ultraviolet light being included, the intensity of ultraviolet light can be appropriately adjusted, and the decrease in the accuracy of reliability evaluation due to excessive charge trapping into the gate insulating film 24 can be reduced.

(Second Embodiment)

A semiconductor device testing apparatus according to this embodiment is the same as the semiconductor device testing apparatus of the first embodiment, except for further including a control unit that controls the application of voltage to a semiconductor device and ultraviolet irradiation to the semiconductor device in a synchronous manner. Therefore, the same explanations as those in the first embodiment will not be repeated.

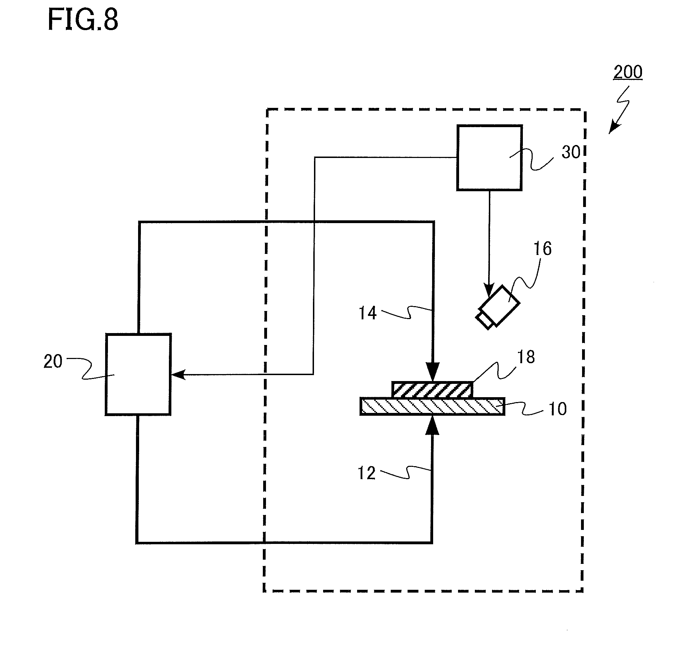

FIG. 8 is a schematic view of the semiconductor device testing apparatus according to this embodiment. The semiconductor device testing apparatus 200 includes a stage 10, a first terminal 12, a second terminal 14, a light source 16, and a control unit 30.

The control unit 30 has the function to automatically control application of voltage to a semiconductor device 18 and ultraviolet irradiation to the semiconductor device 18 in a synchronous manner. Specifically, the control unit 30 automatically controls the power supply 20 and the light source 16 in a synchronous manner.

The control unit 30 is formed with a control circuit and a semiconductor memory storing a control program, for example.

A semiconductor device testing method according to this embodiment involves the above described semiconductor device testing apparatus 200. In the semiconductor device testing method according to this embodiment, after an electrical stress is applied to an insulating film by applying voltage between a semiconductor layer and an electrode under a first condition, voltage is applied between the semiconductor layer and the electrode under a second condition that the absolute value of the voltage to be applied between the semiconductor layer and the electrode is lower than that under the first condition, and the electrical characteristics of the capacitor are evaluated. When the electrical characteristics of the capacitor are evaluated, the ultraviolet irradiation to the semiconductor device is stopped in synchronization with the end of the application of the electrical stress.

According to this embodiment, the application of voltage to the semiconductor device and the ultraviolet irradiation to the semiconductor device are automatically controlled in a synchronous manner. Accordingly, the testing time can be shortened. Also, the operating time of the light source 16 can be shortened, and the life of the light source 16 can be prolonged.

In a case where stress is applied to a MOS capacitor using an n-type semiconductor layer 22 (FIG. 2), control may be performed so that ultraviolet irradiation is performed after the light source 16 is turned on under a negative gate bias condition, and the light source 16 is turned off in synchronization with switching of the bias condition to a positive gate bias condition.

(Third Embodiment)

A semiconductor device manufacturing method according to this embodiment includes: forming an insulating film on a semiconductor layer; forming an electrode on the insulating film; irradiating the semiconductor layer with ultraviolet light; and applying voltage between the semiconductor layer and the electrode under a condition that the electrode has a negative voltage when the semiconductor layer is an n-type semiconductor, and the electrode has a positive voltage when the semiconductor layer is a p-type semiconductor, the semiconductor device being irradiated with the ultraviolet light.

The semiconductor device manufacturing method according to this embodiment is a method of manufacturing a MOSFET using n-type SiC as the semiconductor layer 22.

First, the MOS capacitor structure shown in FIG. 2 is produced. Specifically, a gate insulating film 24 formed with a silicon oxide film is formed on the n-type SiC semiconductor layer 22, for example. After that, a gate electrode 26 that is a stacked film formed with polycrystalline silicon and aluminum is formed on the gate insulating film 24, for example.

In this stage or in the middle of the manufacture of a MOSFET, the reliability of the MOS capacitor is evaluated by using the semiconductor device testing apparatus and the semiconductor device testing method of the first embodiment. The quality of the MOSFET being manufactured is then determined based on the result of the reliability evaluation.

A semiconductor wafer that fails to satisfy a predetermined criterion as a result of the reliability evaluation of the MOS capacitor is determined not to be passed on to the manufacturing process thereafter. A semiconductor wafer that satisfies the predetermined criterion is passed on to the manufacturing process thereafter to manufacture a MOSFET.

According to the semiconductor device manufacturing method of this embodiment, defective wafers can be detected and eliminated in the middle of the manufacturing process. Accordingly, a semiconductor device manufacturing method with high manufacturing efficiency is realized.

Although reliability evaluation has been mainly described in the embodiments so far, the present disclosure can be applied not only to reliability evaluation but also to evaluation of the initial characteristics of semiconductor devices.

Also, in the above embodiments, a negative gate bias condition for a MOS capacitor using an n-type semiconductor layer has been mainly described as an example. However, the present disclosure is also effective in the case of a positive gate bias condition for a MOS capacitor using a p-type semiconductor layer.

While certain embodiments have been described, these embodiments have been presented by way of example only, and are not intended to limit the scope of the inventions. Indeed, the semiconductor device testing apparatus, the semiconductor device testing method, and the semiconductor device manufacturing method herein may be embodied in a variety of other forms; furthermore, various omissions, substitutions and changes in the form of the devices and methods described herein may be made without departing from the spirit of the inventions. The accompanying claims and their equivalents are intended to cover such forms or modifications as would fall within the scope and spirit of the inventions.

**Claims**

1. A semiconductor device testing apparatus comprising:

   a first terminal and a second terminal applying voltage to a semiconductor device; and
   a light source irradiating ultraviolet light to the semiconductor device.

2. The apparatus according to claim 1, further comprising
   a control unit configured to control application of the voltage and irradiation of the ultraviolet light in a synchronous manner.

3. The apparatus according to any preceding claim, wherein the light source has a mechanism to change intensity of the ultraviolet light.

4. The apparatus according to any preceding claim, further comprising
   a conductive stage on which the semiconductor device can be mounted,
   wherein the first terminal is electrically connected to the conductive stage.

5. The apparatus according to any preceding claim, wherein the semiconductor device includes a wide bandgap semiconductor layer.

6. The apparatus according to any preceding claim, wherein
   the semiconductor device includes a capacitor formed with a semiconductor layer, an insulating film provided on the semiconductor layer, and an electrode provided on the insulating film, and
   when the semiconductor layer is an n-type semiconductor, the voltage is applied between the semiconductor layer and the electrode under a condition that the electrode has a negative voltage, and
   when the semiconductor layer is a p-type semiconductor, the voltage is applied between the semiconductor layer and the electrode under a condition that the electrode has a positive voltage.

7. The apparatus according to claim 6, wherein the light source irradiates the ultraviolet light to the capacitor from electrode side.

8. A semiconductor device testing method comprising:

   irradiating a semiconductor device with ultraviolet light, the semiconductor device including a capacitor formed with a semiconductor layer, an insulating film provided on the semiconductor layer, and an electrode provided on the insulating film; and
   applying voltage between the semiconductor layer and the electrode under a first condition that the electrode has a negative voltage when the semiconductor layer is an n-type semiconductor, and the electrode has a positive voltage when the semiconductor layer is a p-type semiconductor, the semiconductor device being irradiated with the ultraviolet light during the applying.

9. The method according to claim 8, wherein the ultraviolet light has a higher energy than a band gap of the semiconductor layer.

10. The method according to either of claims 8 or 9, wherein the semiconductor layer is a wide bandgap semiconductor.

11. The method according to any of claims 8 to 10, wherein, after an electrical stress is applied to the insulating film through the application of the voltage between the semiconductor layer and the electrode under the first condition, voltage is applied between the semiconductor layer and the electrode under a second condition, and electrical characteristics of the capacitor are evaluated.

12. The method according to claim 11, wherein, when the electrical characteristics of the capacitor are evaluated, the ultraviolet irradiation to the semiconductor device is stopped.

**13.** The method according to any of claims 8 to 12, wherein the semiconductor layer is silicon carbide.

**14.** The method according to any of claims 8 to 13, wherein ultraviolet light are irradiated to the capacitor from electrode side.

**15.** The method according to claim 11, wherein, when the electrical characteristics of the capacitor are evaluated, variation in flat band voltage of the capacitor from prior to application of the electrical stress is evaluated, and a defect is detected when the variation exceeds a predetermined value.

**16.** The method according to claim 11, wherein, when the electrical characteristics of the capacitor are evaluated, leakage current of the capacitor is measured, and a defect is detected when the leakage current exceeds a predetermined value.

**17.** The method according to claim 11, wherein an absolute value of the voltage to be applied between the semiconductor layer and the electrode under the second condition is lower than that under the first condition.

**18.** A semiconductor device manufacturing method comprising:

forming an insulating film on a semiconductor layer;
forming an electrode on the insulating film;
irradiating the semiconductor layer with ultraviolet light; and
applying voltage between the semiconductor layer and the electrode under a condition that the electrode has a negative voltage when the semiconductor layer is an n-type semiconductor, and the electrode has a positive voltage when the semiconductor layer is a p-type semiconductor, the semiconductor device being irradiated with the ultraviolet light during the applying.

FIG.1

FIG.2

# FIG.3A

WITHOUT ULTRAVIOLET IRRADIATION

GATE INSULATING FILM

GATE ELECTRODE                     SEMICONDUCTOR LAYER

LOW ELECTRICAL FIELD

# FIG.3B

WITH ULTRAVIOLET IRRADIATION

GATE INSULATING FILM

GATE ELECTRODE                     SEMICONDUCTOR LAYER

ULTRAVIOLET LIGHT

HIGH ELECTRICAL FIELD

# FIG.4

# FIG.5

# FIG.6

# FIG.7A

MOS CAPACITOR    WITH ULTRAVIOLET IRRADIATION

# FIG.7B

MOSFET    WITHOUT ULTRAVIOLET IRRADIATION

FIG.8

Europäisches
Patentamt
European
Patent Office
Office européen
des brevets

# EUROPEAN SEARCH REPORT

Application Number

EP 15 17 2670

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | W. HUANG ET AL: "Comparison of MOS capacitors on n- and p-type GaN", JOURNAL OF ELECTRONIC MATERIALS., vol. 35, no. 4, April 2006 (2006-04), pages 726-732, XP055236949, US ISSN: 0361-5235, DOI: 10.1007/s11664-006-0129-6 * page 726 * * page 729 - page 731; figures 1, 3, 9 * ----- | 1-11,14, 15,17,18 | INV. H01L21/66 G01R31/26 |
| X | BERBERICH S ET AL: "ELECTRICAL CHARACTERISATION OF SI3N4/SIO2 DOUBLE LAYERS ON P-TYPE 6H-SIC", MICROELECTRONICS AND RELIABILITY, ELSEVIER SCIENCE LTD, GB, vol. 40, no. 4/05, April 2000 (2000-04), pages 833-836, XP001191177, ISSN: 0026-2714, DOI: 10.1016/S0026-2714(99)00320-0 | 1-15,17, 18 | |
| Y | * pages 833, 836; figures 2, 5 * ----- | 16 | TECHNICAL FIELDS SEARCHED (IPC) |
| X | NOZAKI S ET AL: "High-quality oxide formed by evaporation of SiO nanopowder: Application to MOSFETs on plastic substrates and GaN epilayers", MATERIALS SCIENCE IN SEMICONDUCTOR PROCESSING, ELSEVIER SCIENCE PUBLISHERS B.V., BARKING, UK, vol. 11, no. 5-6, October 2008 (2008-10), pages 384-389, XP026694299, ISSN: 1369-8001, DOI: 10.1016/J.MSSP.2008.11.005 [retrieved on 2009-01-18] * page 387 - page 388; figure 5 * ----- -/-- | 1-11,14, 15,17,18 | H01L G01R |

The present search report has been drawn up for all claims

| Place of search | Date of completion of the search | Examiner |
|---|---|---|
| Munich | 18 December 2015 | Seck, Martin |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

Europäisches
Patentamt

European
Patent Office

Office européen
des brevets

# EUROPEAN SEARCH REPORT

Application Number

EP 15 17 2670

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 037 288 A1 (S O I TEC SILICON INSULATOR TE [FR]) 18 March 2009 (2009-03-18) * paragraphs [0020], [0050], [0058], [0064], [0069], [0086] - [0088]; figures 1, 2 * | 1-4,6,8, 9 | |
| Y | US 5 543 334 A (YOSHII ICHIRO [JP] ET AL) 6 August 1996 (1996-08-06) * column 4, line 41 - line 52; figure 5 * * column 5, line 21 - line 26 * | 16 | |
| A | | 4,18 | |

TECHNICAL FIELDS
SEARCHED      (IPC)

The present search report has been drawn up for all claims

| Place of search | Date of completion of the search | Examiner |
|---|---|---|
| Munich | 18 December 2015 | Seck, Martin |

CATEGORY OF CITED DOCUMENTS

X : particularly relevant if taken alone
Y : particularly relevant if combined with another
     document of the same category
A : technological background
O : non-written disclosure
P : intermediate document

T : theory or principle underlying the invention
E : earlier patent document, but published on, or
     after the filing date
D : document cited in the application
L : document cited for other reasons

& : member of the same patent family, corresponding
     document

EPO FORM 1503 03.82 (P04C01)

**EP 2 988 326 A1**

## ANNEX TO THE EUROPEAN SEARCH REPORT
## ON EUROPEAN PATENT APPLICATION NO.

EP 15 17 2670

This annex lists the patent family members relating to the patent documents cited in the above-mentioned European search report.
The members are as contained in the European Patent Office EDP file on
The European Patent Office is in no way liable for these particulars which are merely given for the purpose of information.

18-12-2015

| Patent document cited in search report | | | Publication date | Patent family member(s) | | | Publication date |
|---|---|---|---|---|---|---|---|
| EP 2037288 | | A1 | 18-03-2009 | AT | 514095 | T | 15-07-2011 |
| | | | | CN | 101802629 | A | 11-08-2010 |
| | | | | EP | 2037288 | A1 | 18-03-2009 |
| | | | | JP | 4990397 | B2 | 01-08-2012 |
| | | | | JP | 2010539678 | A | 16-12-2010 |
| | | | | KR | 20100057079 | A | 28-05-2010 |
| | | | | US | 2010188094 | A1 | 29-07-2010 |
| | | | | WO | 2009033629 | A1 | 19-03-2009 |
| US 5543334 | | A | 06-08-1996 | JP | 3274924 | B2 | 15-04-2002 |
| | | | | JP | H07169814 | A | 04-07-1995 |
| | | | | US | 5543334 | A | 06-08-1996 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• JP 2014168812 A